# EUROPEAN PATENT APPLICATION

(11) **EP 4 439 786 A2**
(43) Date of publication of application: **02.10.2024**
(21) Application number: 24165231.2
(22) Date of filing: 21.03.2024
(51) Int. Cl.: H01M 10/48, H01M 50/211, H01M 50/503, H01M 50/507, H01M 50/569

(54) **BATTERY PACK AND METHOD OF MANUFACTURING THE BATTERY PACK**

(30) Priority: 27.03.2023 KR 20230039784; 28.06.2023 KR 20230083599
(71) Applicant: Samsung SDI Co., Ltd., Yongin-si, Gyeonggi-do 17084 (KR)
(72) Inventor: YUN, Chuljung, 17084 Yongin-si (KR); AHN, Jaepil, 17084 Yongin-si (KR)
(74) Representative: Marks & Clerk LLP

(57) **Abstract**

A battery pack includes: a plurality of battery cells; busbars respectively connected to the plurality of battery cells; a holder accommodating the busbars; a sensing board seated on the holder, connected to the busbars, and extending in a wavy manner in a first direction; and sensing terminals connecting the busbars to the sensing board and being configured to detect state information about the plurality of battery cells. The sensing board has holes in both sides thereof, and the holder includes protrusions respectively inserted into the holes. In response to the sensing terminals moving, the holes in the sensing board move with respect to the protrusions to stretch the sensing board.

## Description

### BACKGROUND

### 1. Field

Aspects of embodiments of the present disclosure relate to a battery pack and a method of manufacturing the battery pack.

### 2. Description of the Related Art

Generally, secondary batteries are designed to be rechargeable, different from non-rechargeable primary batteries. Secondary batteries are used as energy sources of devices, such as mobile devices, electric vehicles, hybrid electric vehicles, electric bicycles, and uninterruptible power supplies. According to the type of external devices using the secondary batteries, secondary batteries may be used as (or implemented as) single battery cells or battery packs including a plurality of battery cells connected together as a unit.

While small mobile devices, such as mobile phones, may operate for a sufficient time by using an output and a capacity of a single battery, in the case of electric automobiles or hybrid automobiles having relatively large power consumption, a long driving time, and high-power driving, battery packs may be used to meet the power and capacity requirements. An output voltage or an output current of a battery pack may increase as the number of battery cells included therein increases.

### SUMMARY

Embodiments of the present disclosure include a battery pack and a method of manufacturing the battery pack, in which, when a battery cell in the battery pack swells, a sensing board absorbs the displacement that occurs due to the swelling of the battery cell.

However, the above aspects and feature is merely an example, and the aspects and features of the present disclosure are not limited thereto.

Additional aspects and features will be set forth, in part, in the description that follows and, in part, will be apparent from the description or may be learned by practice of the described embodiments of the present disclosure.

A battery pack, according to an embodiment of the present disclosure, includes: a plurality of battery cells; busbars respectively connected to the plurality of battery cells; a holder accommodating the busbars; a sensing board seated on the holder, connected to the busbars, and extending in a wavy manner (i.e. having a wave-shaped geometry) in a first direction; and sensing terminals connecting the busbars to the sensing board and being configured to detect state information about the plurality of battery cells. The sensing board have holes in both sides thereof, and the holder includes protrusions respectively inserted into (i.e. located within) the holes. In response to the sensing terminals moving, the holes in the sensing board move with respect to the protrusions to stretch the sensing board.

Each of the protrusions may include: a protrusion upper portion; and a protrusion connecting portion connecting the protrusion upper portion to the holder. Each of the holes may have: a first hole portion having a first hole portion width corresponding to a width of the protrusion upper portion; and a second hole portion having a second hole portion width corresponding to a width of the protrusion connecting portion.

The protrusion upper portions may extend through the first hole portions, respectively, and the protrusion connecting portions may respectively pass through the first hole portions and/or the second hole portions.

The battery pack may further include sensing board connecting portions respectively connecting the sensing terminals to the sensing board, and each of the sensing board connecting portions may be connected to a portion of the sensing board in a direction perpendicular to the first direction.

In response to displacement of the sensing terminals in the first direction, the sensing board may be stretched in the first direction to absorb the displacement by up to a first displacement value, and the sensing board connecting portions may be deformed in a direction perpendicular to a connection direction between the sensing board connecting portions and the sensing terminals to absorb the displacement by up to a second displacement value.

The battery pack may further include sensing board connecting portions respectively connecting the sensing terminals to the sensing board. Each of the sensing board connecting portions may be connected to a portion of the sensing board in a direction parallel to the first direction.

In response to displacement of the sensing terminals in the first direction, the sensing board may be stretched in the first direction to absorb the displacement by up to a first displacement value, and the sensing board connecting portions may be deformed in a direction parallel to a connection direction between the sensing board connecting portions and the sensing terminals to absorb the displacement by up to a second displacement value.

The sensing board may have a first area forming an edge portion of the sensing board and a second area forming an inner edge portion of the sensing board. The sensing board may include: a sensing terminal connecting portion at an end of the sensing terminal and electrically connected to the sensing board passes through the first area to be coupled to the second area of the sensing board; a first circuit path formed in the first direction of the sensing board; a second circuit path passing through the first area and electrically connected to the sensing terminal and another sensing terminal; and a third circuit path electrically connected to the sensing terminal connecting portion of the sensing board in the second area. The first circuit path, the second circuit path, and the third circuit path may not overlap each other.

The protrusion upper portions of the protrusions may be respectively coupled to the protrusion connecting portions by a heat stacking method.

The protrusion upper portions of the protrusions may be caps respectively fitted onto the protrusion connecting portions.

The protrusion upper portions of the protrusions may respectively include snap-fit portions, and the snap-fit portions may be snap-fit to the sensing board.

A method of manufacturing a battery pack, according to an embodiment of the present disclosure, includes: coupling a wavy sensing board (i.e. a sensing board having a wave geometry) to a holder by inserting protrusions of the holder into holes in the sensing board, respectively; maintaining a free state in which waviness of the sensing board coupled to the protrusions is released (e.g. to a certain extent, or partially released) by a tensile force of the sensing board and no external force is applied to the sensing board (e.g. such that the waviness of the sensing board has an amplitude greater than zero and less than a maximum amplitude); and in response to sensing terminals being moved, absorbing, by the sensing board coupled to the sensing terminals, displacement of the sensing terminals while being stretched in accordance with movements of the sensing terminals.

The battery pack may include sensing board connecting portions that connect the sensing terminals to the sensing board, respectively, and are each connected to a portion of the sensing board in a direction perpendicular to a first direction. The absorbing, by the sensing board coupled to the sensing terminals, of the displacement of the sensing terminals in response to the sensing terminals being moved while being stretched in accordance with the movements of the sensing terminals may include: in response to displacement of the sensing terminals in the first direction, absorbing, by the sensing board being stretched in the first direction, the displacement by up to a first displacement value; and absorbing, by the sensing board connecting portions being deformed in a direction perpendicular to a connection direction between the sensing board connecting portions and the sensing terminals, the displacement by up to a second displacement value.

The battery pack may further include sensing board connecting portions that connect the sensing terminals to the sensing board, respectively, and are each connected to a portion of the sensing board in a direction parallel to a first direction. The absorbing, by the sensing board coupled to the sensing terminals, of the displacement of the sensing terminals in response to the sensing terminals being moved while being stretched in accordance with the movements of the sensing terminals may include, in response to displacement of the sensing terminals in the first direction: absorbing, by the sensing board being stretched in the first direction, the displacement by up to a first displacement value; and absorbing, by the sensing board connecting portions being deformed in a direction parallel to a connection direction between the sensing board connecting portions and the sensing terminals, the displacement by up to a second displacement value.

The coupling of the wavy sensing board to the holder by inserting the protrusions of the holder into the holes of the sensing board, respectively, may include: inserting protrusion connecting portions of the holder into the holes in the sensing board, respectively; and coupling protrusion upper portions to the protrusion connecting portions coupled to the holes, respectively.

Aspects and features other than those described above will become clear from the following detailed description, claims, and drawings. At least some of the above and other features of the invention are set out in the claims.

### BRIEF DESCRIPTION OF THE DRAWINGS

The above and other aspects and features of the present disclosure will be more apparent from the following description taken in conjunction with the accompanying drawings, in which:
FIG. 1 is an exploded perspective view of a battery pack according to embodiments of the present disclosure;
FIG. 2A is a diagram illustrating a wavy sensing board coupled to protrusions of a holder through insertion according to embodiments of the present disclosure;
FIG. 2B is a cross-sectional perspective view taken along the line A-A of FIG. 2A;
FIG. 3A is a diagram illustrating a sensing board is stretched to be flat and is coupled to protrusions of a holder through insertion according to embodiments of the present disclosure;
FIG. 3B is a cross-sectional perspective view taken along the line B-B of FIG. 3A;
FIG. 4A is an enlarged view of protrusion upper portions and protrusion connecting portions according to embodiments of the present disclosure;
FIG. 4B is a diagram illustrating shapes of hole portions in a sensing board coupled to protrusions shown in FIG. 4A;
FIG. 5A is a diagram illustrating a wavy sensing board coupled to a holder by inserting holes in the sensing board onto protrusions of the holder, respectively, according to embodiment of the present disclosure;
FIG. 5B is a cross-sectional perspective view taken along the line C-C of FIG. 5A;
FIG. 6A is a diagram illustrating a free state in which waviness of a sensing board coupled to protrusions is released by a tensile force of the sensing board such that no external force is applied to the sensing board according to embodiments of the present disclosure;
FIG. 6B is a cross-sectional perspective view taken along the line D-D of FIG. 6A;
FIG. 7A is a diagram illustrating a state in which a sensing board coupled to the sensing terminals is stretched in accordance with movements of the sensing terminals to absorb a displacement of the sensing terminals according to embodiments of the present disclosure;
FIG. 7B is a cross-sectional perspective view taken along the line E-E of FIG. 7A;
FIG. 8 is a diagram illustrating a plurality of sensing boards arranged in a process of manufacturing sensing boards according to embodiments of the present disclosure;
FIG. 9 is a diagram illustrating a plurality of non-overlapping circuit paths inside a sensing board according to embodiments of the present disclosure;
FIG. 10A is a diagram illustrating a structure of a sensing board and sensing terminals coupled thereto according to embodiments of the present disclosure;
FIG. 10B is a diagram illustrating a state in which, a sensing board is stretched to absorb displacement of the sensing terminals shown in FIG. 10A by up to a first displacement value D1;
FIG. 10C is a diagram illustrating a state in which, when a displacement of the sensing terminals shown in FIG. 10A occurs, sensing board connecting portions are deformed in a direction perpendicular to a connection direction between the sensing board connecting portions and the sensing terminals to absorb the displacement by up to a second displacement value D2;
FIG. 11A is a diagram illustrating a structure of a sensing board and sensing terminals coupled thereto according to embodiments of the present disclosure;
FIG. 11B includes diagrams showing how, when a displacement of the sensing terminals of FIG. 11A occurs, a sensing board is stretched to absorb the displacement by up to a first displacement value D1';
FIG. 12A is a diagram illustrating a structure of a sensing board and sensing terminals coupled thereto according to embodiments of the present disclosure;
FIG. 12B includes diagrams showing how, when a displacement of the sensing terminals shown in FIG. 12A occurs, a sensing board is stretched to absorb the displacement by up to a first displacement value D1";
FIG. 12C includes diagrams showing how, when a displacement of the sensing terminals shown in FIG. 12A occurs, sensing board connecting portions are deformed in a direction perpendicular to a connection direction between the sensing board connecting portions and the sensing terminals to absorb the displacement by up to a second displacement value D2";
FIG. 13A is a diagram illustrating a state in which protrusion connecting portions of a holder are inserted into holes in a sensing board, respectively, according to embodiments of the present disclosure;
FIG. 13B is a diagram illustrating a state in which protrusion upper portions are coupled to the protrusion connecting portions shown in FIG. 13A by using a heat stacking method;
FIG. 13C includes diagrams showing how a sensing board shown in FIG. 13B is stretched to be flat;
FIG. 14A is a diagram illustrating a state in which protrusion connecting portions of a holder are inserted into holes in a sensing board, respectively, according to embodiments of the present disclosure;
FIG. 14B is a diagram illustrating a state in which protrusion upper portions formed as caps are fitted into the protrusion connecting portions shown in FIG. 14A, respectively;
FIG. 14C includes diagrams showing how a sensing board shown in FIG. 14B is stretched to be flat;
FIG. 15A is a diagram illustrating a state in which unspread snap-fit portions of a holder are inserted into holes in a sensing board, respectively, according to embodiments of the present disclosure;
FIG. 15B is a diagram illustrating a state in which, after insertion of the snap-fit portions into holes in the sensing board shown in FIG. 15A is completed, the sensing board is coupled to the snap-fit portions by releasing an external force applied to the snap-fit portions such that the snap-fit portions are spread apart;
FIG. 15C includes diagrams showing how the sensing board shown in FIG. 15B is stretched to be flat; and
FIG. 16 is a flowchart describing a method of controlling a substrate processing apparatus according to embodiments of the present disclosure.

### DETAILED DESCRIPTION

Reference will now be made, in detail, to embodiments, examples of which are illustrated in the accompanying drawings. The described embodiments may have different forms and should not be construed as being limited to the descriptions set forth herein. Accordingly, embodiments are merely described below, by referring to the figures, to explain aspects and features of the present description.

Because the present disclosure allows for various changes and numerous embodiments, some embodiments will be illustrated in the drawings and described in detail. However, this is not intended to limit the present disclosure, and it is to be appreciated that all changes, equivalents, and substitutes that do not depart from the spirit and technical scope of the present disclosure are encompassed in the present disclosure.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

When a certain embodiment may be implemented differently, particular operations may be performed differently from the sequence described herein. For example, two processes, which are successively described herein, may be substantially concurrently or simultaneously performed or may be performed in a process sequence opposite to a described process sequence.

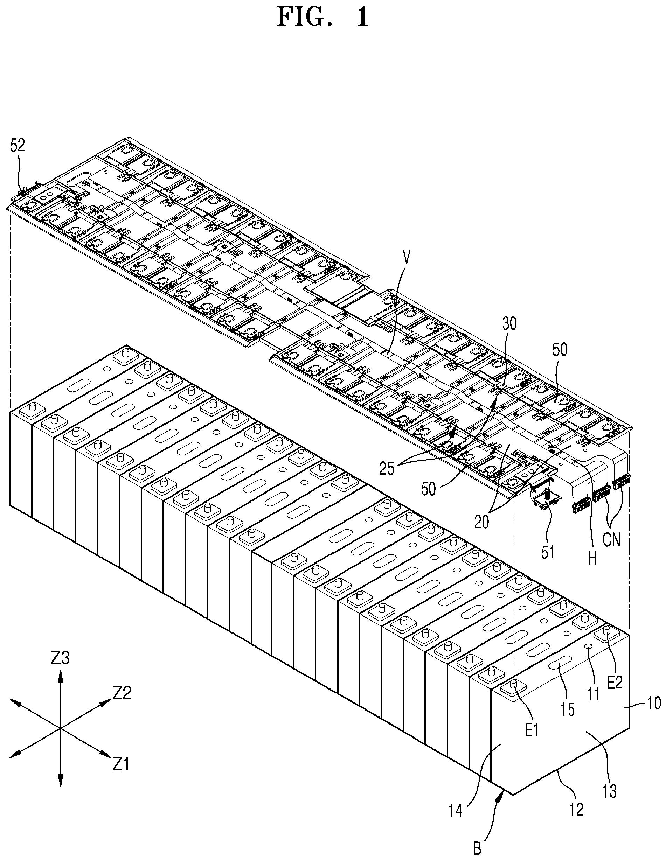

Hereinafter, a battery pack according to embodiments of the present disclosure will be described with reference to FIGS. 1, 2A, 2B, 3A, 3B, 4A, and 4B.

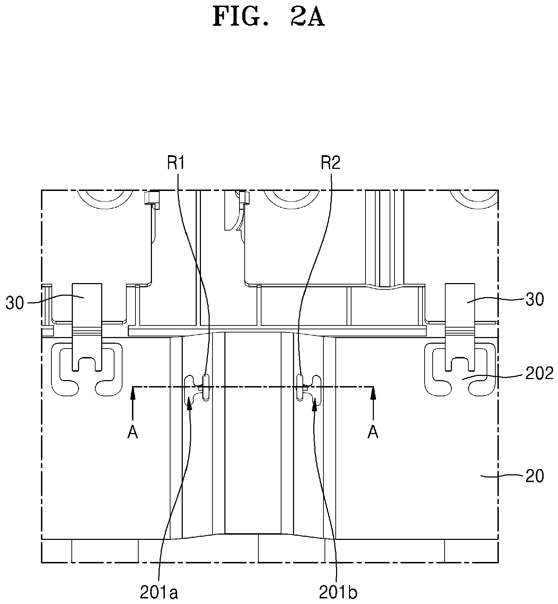

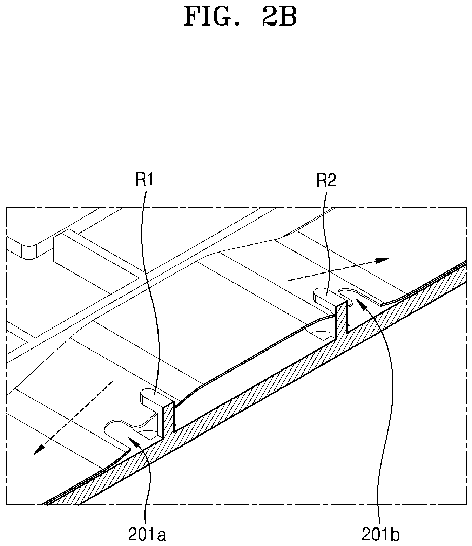

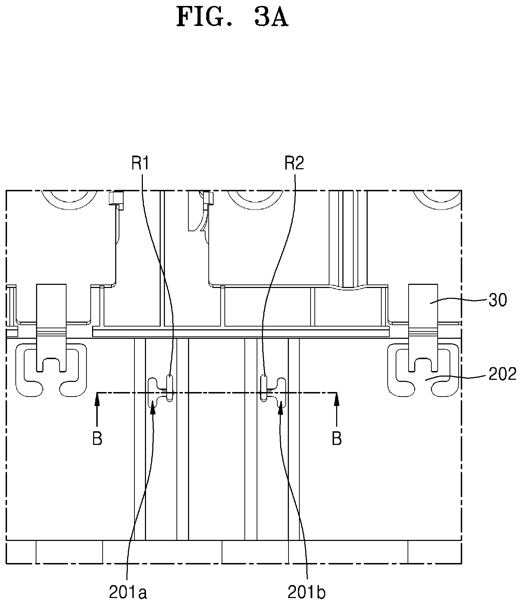

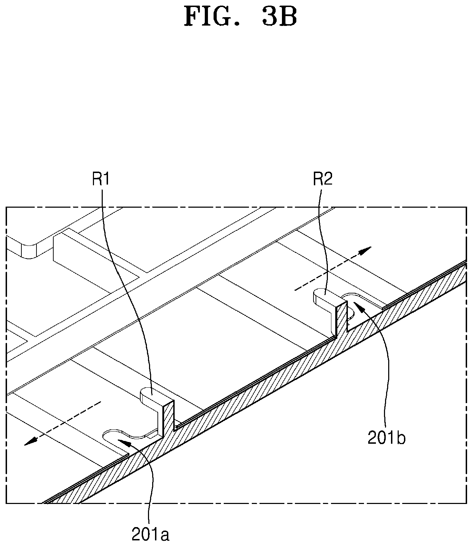

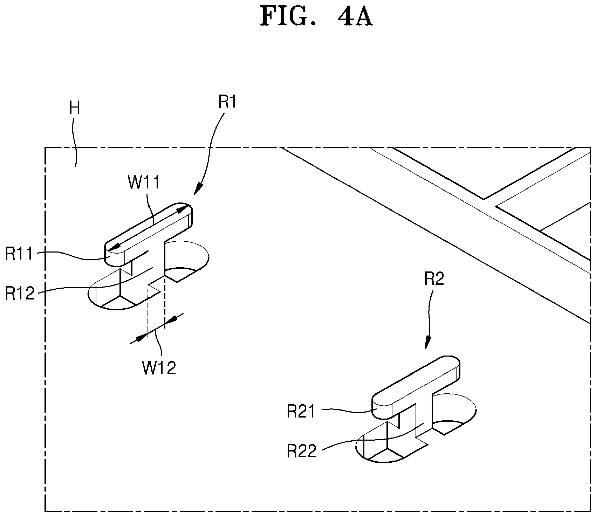

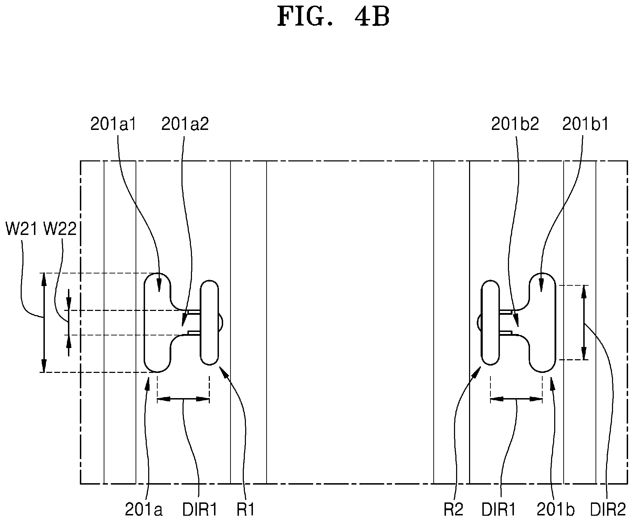

FIG. 1 is an exploded perspective view of a battery pack according to embodiments of the present disclosure. FIG. 2A is a diagram illustrating a wavy sensing board coupled to protrusions of a holder through insertion according to embodiments of the present disclosure. FIG. 2B is a cross-sectional perspective view taken along the line A-A of FIG. 2A. FIG. 3A is a diagram illustrating a sensing board is stretched to be flat and coupled to protrusions of a holder through insertion according to embodiments of the present disclosure. FIG. 3B is a cross-sectional perspective view taken along the line B-B of FIG. 3A. FIG. 4A is an enlarged view illustrating protrusion upper portions and protrusion connecting portions according to embodiments of the present disclosure. FIG. 4B is a diagram illustrating shapes of hole portions in a sensing board coupled to protrusions shown in FIG. 4A.

Referring to FIGS. 1, 2A, 2B, 3A, 3B, 4A, and 4B, the battery pack according to embodiments of the present disclosure may include a plurality of battery cells B arranged in a first direction Z1 and busbars 50 arranged on the plurality of battery cells B to electrically connect different ones of the battery cells B to each other.

A holder H may be arranged between the busbars 50 and the battery cells B to electrically insulate the busbars 50 from the battery cells B and to align assembly positions of the busbars 50. Sensing boards 20 for collecting state information about the battery cells B may be arranged on the holder H along with the busbars 50. In some embodiments of the present disclosure, the busbar 50 may be connected to first and second electrode terminals E1 and E2 of the battery cells B having opposite polarities, which are arranged on a terminal surface 11 of the battery cells B in a second direction Z2 crossing the first direction Z1.

The first and second electrode terminals E1 and E2 may be arranged in (or may form) first and second rows of electrode terminals E1 and E2 in the first direction Z1, and the busbars 50 electrically connected to the first and second rows of electrode terminals E1 and E2 may be arranged in (or may form) first and second rows of busbars 50 on (or over) the first and second rows of electrode terminals E1 and E2. In addition, the sensing boards 20 for collecting state information about the plurality of battery cells B may be arranged between the first and second rows of electrode terminals E1 and E2 or between the first and second rows of busbars 50. For example, the first and second rows of busbars 50 and the sensing boards 20 arranged between the first and second rows of busbars 50 may be supported together on the holder H and may be arranged on the holder H such that their assembly positions are aligned and they may be insulated from the battery cells B.

The battery cell B may have the terminal surface 11 on which the first and second electrode terminals E1 and E2 are formed, a bottom surface 12 opposite to the terminal surface 11, and side surfaces 13 and 14 connecting (or extending between) the terminal surface 11 and the bottom surface 12. The wide side surfaces 13 occupy a relatively large area, and the narrow side surfaces 14 occupy a relatively small area.

For example, the plurality of battery cells B arranged in the first direction Z1 may be arranged such that the wide side surfaces 13 of different battery cells B face each other. A vent 15 for relieving internal pressure in the battery cell B may be formed between the first and second electrode terminals E1 and E2 having opposite polarities on the terminal surface 11 of the battery cell B, and a vent hole V for allowing the flow of exhaust gas discharged through the vent 15 of the battery cell B may be formed in each of the holder H and the sensing board 20 arranged on the vent 15.

A connector CN electrically connected to the sensing board 20 may be formed at one end of the sensing board 20, and an electrical connection between the sensing board 20 and a battery management unit may be established through the connector CN.

The busbar 50 may electrically connect different battery cells B to each other, and a plurality of busbars 50 electrically connected to each other may be electrically connected to an external device through input/output terminals 51 and 52. The input/output terminals 51 and 52 may include a pair of different input/output terminals 51 and 52 connected to the battery cells B at one end and the other end, respectively, or to the busbars 50 connected to the battery cells B at one end and the other end, respectively. The external device to which the plurality of battery cells B are connected through the input/output terminals 51 and 52 may correspond to an external load for receiving discharge power from the battery pack or an external charger for supplying charging power to the battery pack.

The sensing board 20 is formed having the lengthwise direction in the first direction Z1 and has an edge formed in a direction parallel to the first direction Z1. Sensing terminals 30 are connected to an edge portion of the sensing board 20. The sensing terminals 30 may collect state information about a plurality of battery cells B.

The sensing terminals 30 may be connected to the busbars 50 to collect state information about the plurality of battery cells B connected to the busbars 50. Here, the sensing terminal 30 may measure state information about the battery cell B, such as temperature, voltage, or current, and for example, the sensing terminal 30 may include a thermistor for measuring a temperature by using a characteristic in which resistance increases or decreases according to the temperature, such as a positive temperature coefficient (PTC) thermistor or a negative temperature coefficient (NTC) thermistor for measuring the temperature of the battery cell B. An electrical signal corresponding to temperature information of the battery cell B may be generated and output.

According to embodiments of the present disclosure, the battery pack includes the plurality of battery cells B, the holder H accommodating the busbars 50 connected to the plurality of battery cells B, the sensing boards 20 that are seated on the holder H, connected to the busbars 50, and extend in the first direction Z1 to have a wavy shape (i.e. the sensing boards 20 are shaped to have a wave geometry in the first direction Z1), and the sensing terminals 30 that connect the busbars 50 to the sensing boards 20 and detect state information about the plurality of battery cells B.

The sensing board 20 has holes (e.g., openings) 201a and 201b formed in both sides of the sensing board 20, the holder H includes protrusions R1 and R2 inserted into the holes 201a and 201b, respectively. When the sensing terminal 30 is moved, the positions of the hole portions 201a and 201b in the sensing board 20 are moved with respect to the protrusions R1 and R2 such that the sensing board 20 is stretched.

The sensing board 20 may be seated on the holder H. In one embodiment, the sensing board 20 may be formed with the lengthwise direction in the first direction Z1 and to have a wavy shape in the first direction Z1.

When the plurality of battery cells B swell, the busbars 50 connecting the plurality of battery cells B to each other and the sensing terminal 30 connected to the busbars 50 may be moved in the direction of the swelling of the battery cells B. According to the illustrated embodiment, because the plurality of battery cells B are arranged in the first direction Z1 and the areas of the side surfaces 13 of the plurality of battery cells B in the first direction Z1 are larger than the areas of the side surfaces 14 in a second direction Z2, the plurality of battery cells B expand in (e.g., primarily expand in) the first direction Z1 when swelling occurs. Thus, the busbars 50 and the sensing terminals 30 connected to the plurality of battery cells B may also be moved in the first direction Z1.

Here, the sensing board 20 extends in the first direction Z1 to have a wavy shape. When the plurality of battery cells B swell, and in response to the movements of the busbars 50 and the sensing terminals 30 connected to the plurality of battery cells B in the first direction Z1 due to the swelling, the sensing boards 20 may absorb displacement of the busbars 50 and the sensing terminals 30 by changing the waviness of the sensing boards 20 (e.g. by extending such that the waviness has a lower magnitude). The sensing boards 20 may absorb displacement of the busbars 50 and the sensing terminals 30 to absorb changes to the size of the plurality of battery cells B when swelling occurs in the plurality of battery cells B so that the connection between the sensing boards 20 and the plurality of battery cells B, the connection between the plurality of battery cells B and the connector CN through the sensing boards 20, and/or the connection between the plurality of battery cells B and the input/output terminals 51 and 52 through the sensing boards 20 may be stably maintained.

According to the illustrated embodiment, as the plurality of battery cells B expand, the sensing board 20 having the wavy shape may absorb displacement of the busbars 50 or the sensing terminals 30 by being deformed from the wavy shape to a flat (or flatter) shape (i.e. a wave with a lower magnitude). Thus, the maximum value of the displacement absorbed by the sensing board 20 may be a distance by which the sensing terminals 30 coupled to the sensing board 20, which has the wavy shape when an external force is not applied thereto, are moved until the waviness of the sensing board 20 becomes zero (e.g., when the sensing board 20 is completely flat) due to the movement of the sensing terminals 30 coupled to the sensing board 20.

The direction of the waviness of the sensing board 20 is illustrated and described as being in the first direction Z1 but may also be the second direction Z2 according to the arrangement and arrangement direction of the plurality of battery cells B. In addition, depending on the arrangement of the sensing terminals 30 and the busbars 50, the interval between waves on the sensing board 20 or the size of the waves may vary.

The sensing board 20 may be formed of (e.g., the sensing board 20 may be) a flexible printed circuit (FPC) film. The wavy sensing board 20 may be easily manufactured by using the FPC film because it is flexible and, thus, easily bendable.

According to the illustrated embodiment, the protrusions R1 and R2 include protrusion upper portions R11 and R21 and protrusion connecting portions R12 and R22 connecting the protrusion upper portions R11 and R21 to the holder H, respectively (see, e.g., FIG. 4A). Here, the hole portions 201a and 201b include first hole portions 201a1 and 201b1 having a first hole portion width W21 corresponding to the width of the protrusion upper portions R11 and R21 and second hole portions 201a2 and 201b2 having a second hole portion width W22 corresponding to the width of the protrusion connecting portions R12 and R22, respectively (see, e.g., FIG. 4B).

By coupling the holes 201a and 201b in the sensing board 20 to the protrusions R1 and R2, respectively, and then releasing the external force acting on the sensing board 20, the sensing board 20 may be kept wavy (e.g., may be maintained in a wavy state) to a certain extent as illustrated in FIGS. 2A and 2B.

When swelling occurs in the plurality of battery cells B in the state shown in FIGS. 2A and 2B and the positions of the busbars 50 or the sensing terminals 30 are changed, the sensing board 20 may be deformed from the wavy shape shown in FIGS. 2A and 2B to a flat shape shown in FIGS. 3A and 3B to absorb the changes in the positions of the sensing terminals 30 and, thus, absorb a displacement of the sensing terminals 30.

Referring to FIGS. 4A and 4B, the protrusion upper portions R11 and R21 are formed to correspond to the first hole portions 201a1 and 201b1, respectively, and the protrusion connecting portions R12 and R22 are formed to correspond to the second hole portions 201a2 and 201b2, respectively. A protrusion connecting portion width W12 of the protrusion connecting portions R12 and R22 is less than a protrusion upper portion width W11. The protrusion upper portions R11 and R21 are formed to be able to pass through the first hole portions 201a1 and 201b1, respectively, such that the first hole portions 201a1 and 201b1 pass through the protrusion upper portions R11 and R21, respectively, and thus, the sensing board 20 may be coupled to the holder H. After the first hole portions 201a1 and 201b1 are coupled to protrusion upper portions R11 and R21, respectively, the second hole portions 201a2 and 201b2 are moved with respect to the protrusion connecting portions R12 and R22, respectively, and because the second hole portion width W22 of the second hole portions 201a2 and 201b2 is less than the protrusion upper portion width W11, the sensing board 20 is only moved while the protrusions R1 and R2 extend therethrough and is unable to escape from (e.g., cannot become disconnected from) the protrusions R1 and R2.

The second hole portions 201a2 and 201b2 may be moved in first moving directions DIR1 through the protrusion connecting portions R12 and R22 having the protrusion connecting portion width W12 corresponding to the second hole portion width W22. Each of the second hole portions 201a2 and 201b2 is moved only in a direction to get closer to or to move away from each other. When the second hole portions 201a2 and 201b2 are moved closer to each other, the waviness of the sensing board 20 may increase (or may become larger). When the second hole portions 201a2 and 201b2 are moved away from each other, the waviness of the sensing board 20 may decrease (or may become smaller).

The description of the illustrated embodiment has focused on the movement of the second hole portions 201a2 and 201b2 in the sensing board 20 in only the first moving directions DIR1 parallel to the first direction Z1, but the second hole portions 201a2 and 201b2 may also be moved with respect to the protrusion connecting portions R12 and R22 in second moving directions DIR2 perpendicular to the first moving directions DIR1 and, thus, may absorb swelling of the plurality of battery cells B in other directions as well.

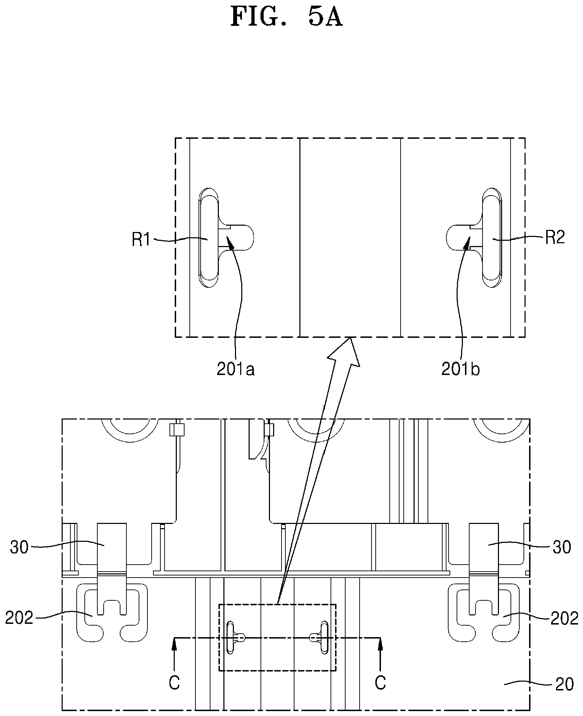

Hereinafter, a method of manufacturing a battery pack according to embodiments of the present disclosure will be described with reference to FIGS. 5A, 5B, 6A, 6B, 7A, 7B, and 16. Details not illustrated or described in FIGS. 5A, 5B, 6A, 6B, 7A, and 7B may refer to FIGS. 1, 2A, 2B, 3A, 3B, 4A, and 4B.

The method of manufacturing a battery pack according to an embodiment includes coupling the sensing board 20 to the holder H by inserting the protrusions R1 and R2 of the holder H into the holes 201a and 201b in the wavy sensing board 20, respectively (S1), maintaining a free state in which the waviness of the sensing board 20 coupled to the protrusions R1 and R2 is released to a certain extent by the tensile force of the sensing board 20 and while no external force is applied to the sensing board 20 (S2). When the sensing terminals 30 are moved, absorbing, by the sensing board 20 coupled to the sensing terminals 30, a displacement of the sensing terminals 30 while being stretched in accordance with movements of the sensing terminals 30 (S3).

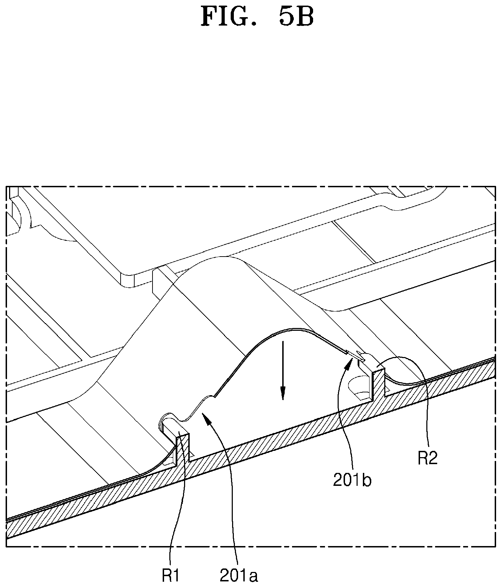

Referring to FIGS. 5A and 5B, to couple the sensing board 20 to the holder H (S1), the sensing board 20 is brought into an unstretched (i.e. maximally wavy, or a wave with maximum amplitude) state such that the center portions of the holes 201a and 201b are located at uppermost positions and, thus, the hole portions 201a and 201b are located to correspond to the protrusions R1 and R2, respectively. Then, the sensing board 20 may be coupled to the holder H by inserting the protrusion upper portions R11 and R21 into the first hole portions 201a1 and 201b1 corresponding to the protrusion upper portions R11 and R21, respectively. After the protrusion upper portions R11 and R21 are inserted into the first hole portions 201a1 and 201b1, because the second hole portions 201a2 and 201b2 are narrower than the protrusion upper portions R11 and R21, respectively, the protrusion upper portions R11 and R21 may be caught by the second hole portions 201a2 and 201b2 such that the sensing board 20 may be caught by and coupled to the protrusions R1 and R2.

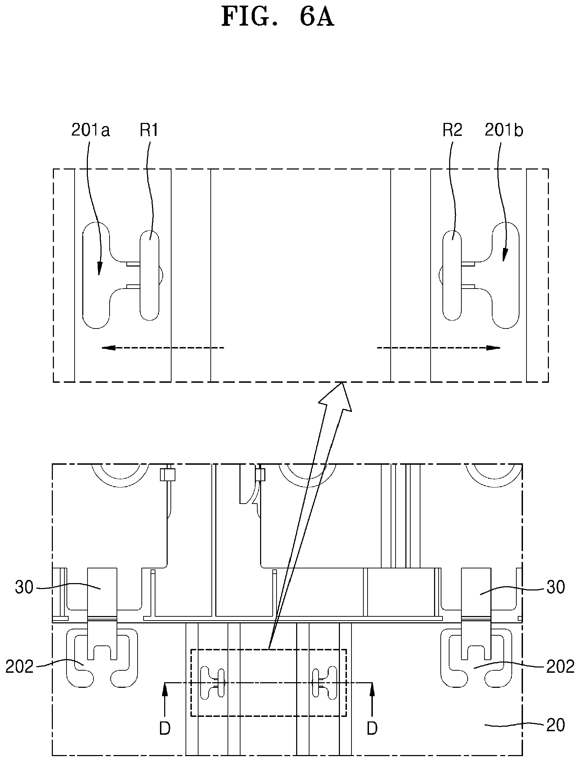

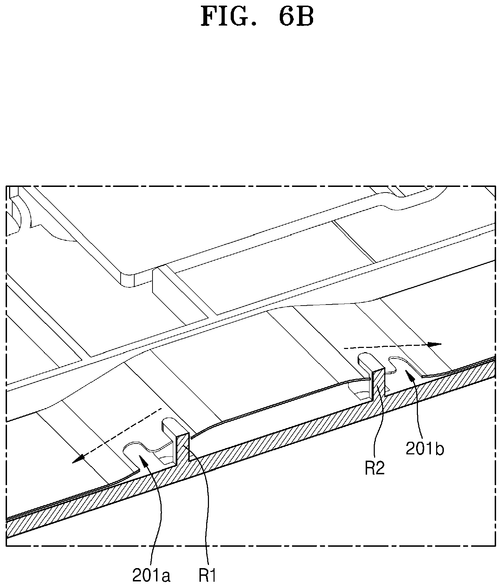

Then, referring to FIGS. 6A and 6B, when the sensing board 20 is coupled to the protrusions R1 and R2, the external force applied to make the sensing board 20 unstretched when coupling the sensing board 20 to the protrusions R1 and R2 is released, the waviness of the sensing board 20 is released to a certain extent (i.e. the sensing board 20 reverts to a geometry having a waviness with a magnitude greater than zero and less than the aforementioned maximum amplitude) by the tensile force of the sensing board 20 and, thus, a free state in which no external force is applied to the sensing board 20 may be maintained (S2). In this configuration, the waviness of the sensing board 20 does not become zero, and the sensing board 20 may be kept coupled to the protrusions R1 and R2 while being wavy to a certain extent.

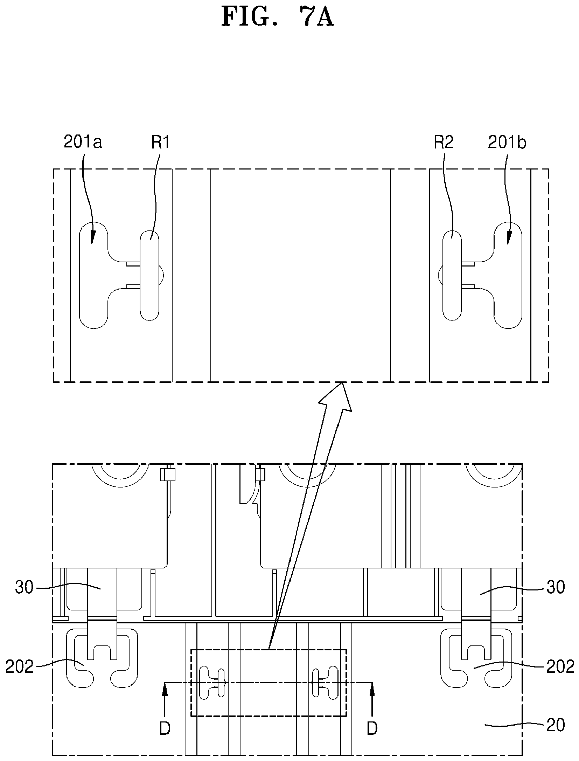

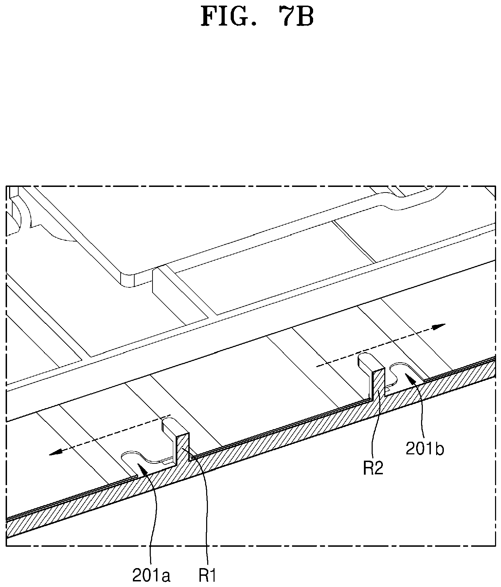

Then, referring to FIGS. 7A and 7B, when the sensing terminals 30 are moved due to swelling of the plurality of battery cells B, the sensing board 20 coupled to the sensing terminals 30 may be stretched in accordance with movements of the sensing terminals 30 and, thus, absorbs a displacement of the sensing terminals 30 (S3).

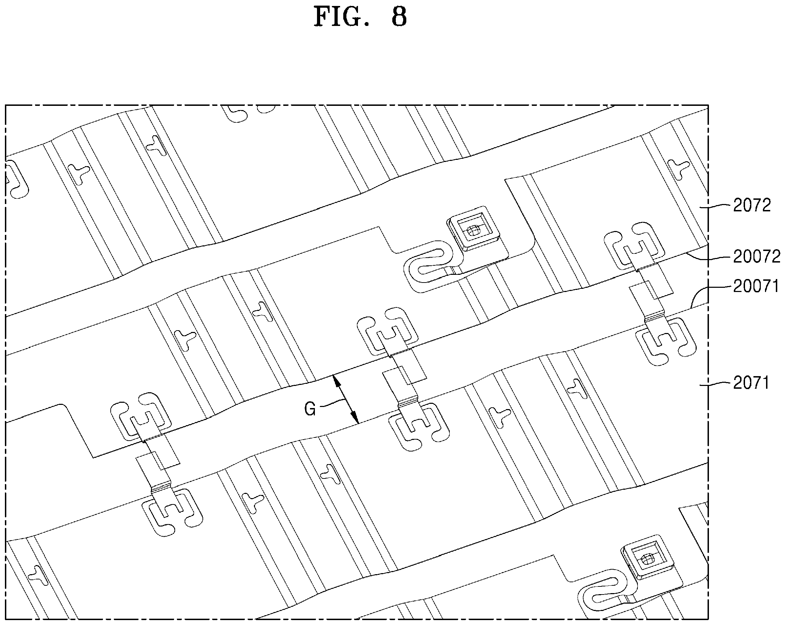

FIG. 8 is a diagram illustrating a plurality of sensing boards arranged in a process of manufacturing sensing boards according to embodiments of the present disclosure.

Referring to FIG. 8, the sensing boards according to embodiments may be arranged in the manufacturing process such that edges 200n1 and 200n2 of two adjacent sensing boards 20n1 and 20n2 are parallel to each other. Conventional sensing boards including sensing terminals having an S-curve shape (e.g., a meandering shape) need to be manufactured with a wide interval G between the boards during the manufacturing process to avoid interference between the sensing terminals. Because the area occupied by one sensing board increases by the interval G, the productivity and efficiency may decrease. However, according to the present embodiment, because the sensing boards 20 are formed to have a substantially rectangular shape and adjacent edge portions are parallel to each other in the manufacturing process, the manufacture may be seamlessly performed even when the interval G between the sensing boards in the manufacturing process is narrow. Thus, the area occupied by the sensing boards being manufactured may be reduced, and the overall productivity and efficiency of the sensing boards may be improved with an increase in the number of manufactured sensing boards per unit area. In addition, while it may be difficult to process the conventional sensing board including the meandering-shaped sensing terminals due to its morphological features, according to the present embodiment, the edge of the sensing board 20 is formed in a straight line shape. Thus, mold processing is simplified, and process simplification and production cost reduction may be achieved.

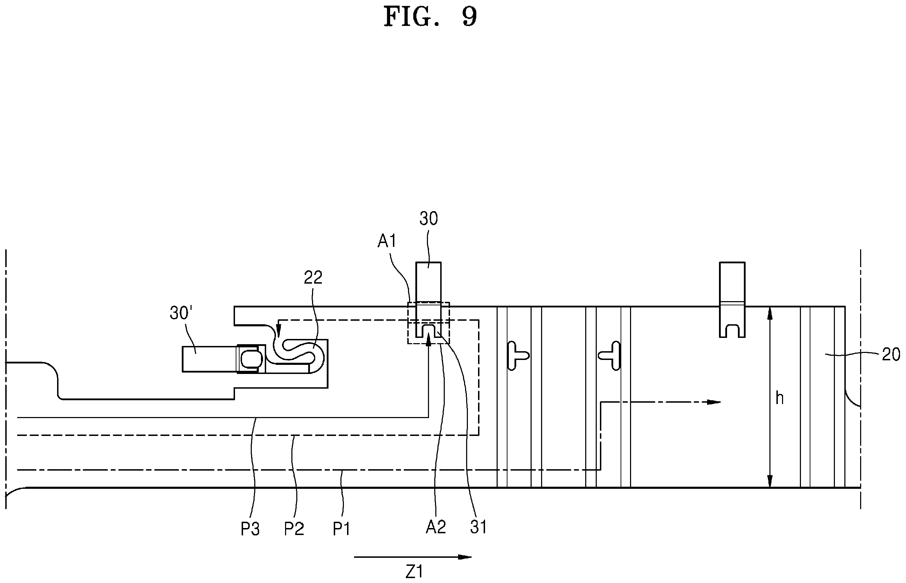

FIG. 9 is a diagram illustrating a plurality of non-overlapping circuit paths inside a sensing board according to embodiments of the present disclosure.

Referring to FIG. 9, the sensing board 20 may have a sensing board height h. This is because, as illustrated in FIG. 8, the interval G between sensing boards during the manufacturing process may be reduced or minimized such that the height h of each sensing board 20 may be increased or maximized. By maximizing the height h of the sensing board 20, a circuit implementation space arranged inside the sensing board 20 increases, and thus, the performance of the sensing board 20 may be improved.

In addition, the sensing board 20 has a first area A1 forming an edge portion of the sensing board 20 and a second area A2 forming an inner edge portion of the sensing board 20, a sensing terminal connecting portion 31 formed at an end of the sensing terminal 30 and electrically connected to the sensing board 20 passes through the first area A1 to be coupled to the second area A2 of the sensing board 20, and circuit paths in the sensing board 20 include a first circuit path P1 formed in the sensing board 20 in the first direction Z1, a second circuit path P2 passing through the first area A1 of the sensing board 20 to be electrically connected to the sensing terminal 30 and another sensing terminal 30', and a third circuit path P3 electrically connected to the sensing terminal connecting portion 31 of the sensing terminal 30 in the second area A2 of the sensing board 20. The first, second, and third circuit paths P1, P2, and P3 do not overlap each other. That is, according to the illustrated embodiment, because the second circuit path P2 connected to the other sensing terminal 30' has a circuit path structure in which the second circuit path P2 passes through the first area A1 at where the sensing terminal 30 is arranged (e.g., other than the sensing terminal connecting portion 31 included in the second area A2 of the sensing board 20) to be connected to the other sensing terminal 30', the circuit paths P1 and P2 are respectively connected to the sensing terminals 30 and 30' without overlapping each other, and thus, the circuit performance of the sensing board 20 may be secured.

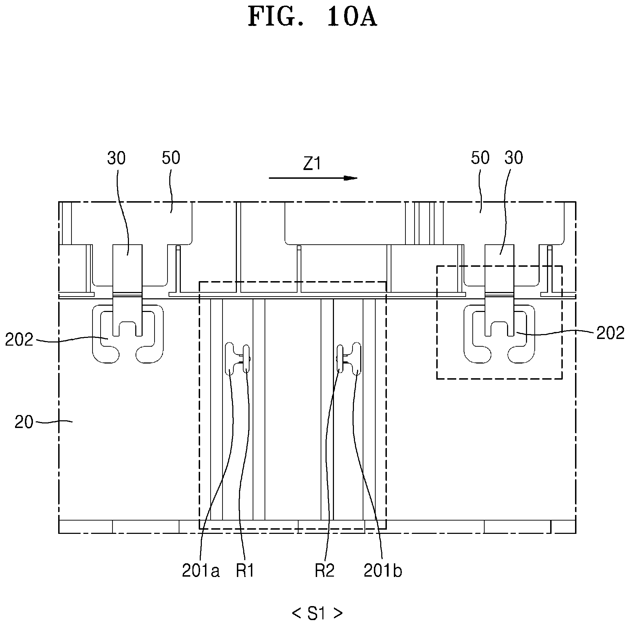

Hereinafter, a structure of a sensing board of a battery pack and a method of manufacturing the battery pack according to embodiments will be described with reference to FIGS. 10A, 10B, 10C, 11A, 11B, 12A, 12B, 12C, and 16.

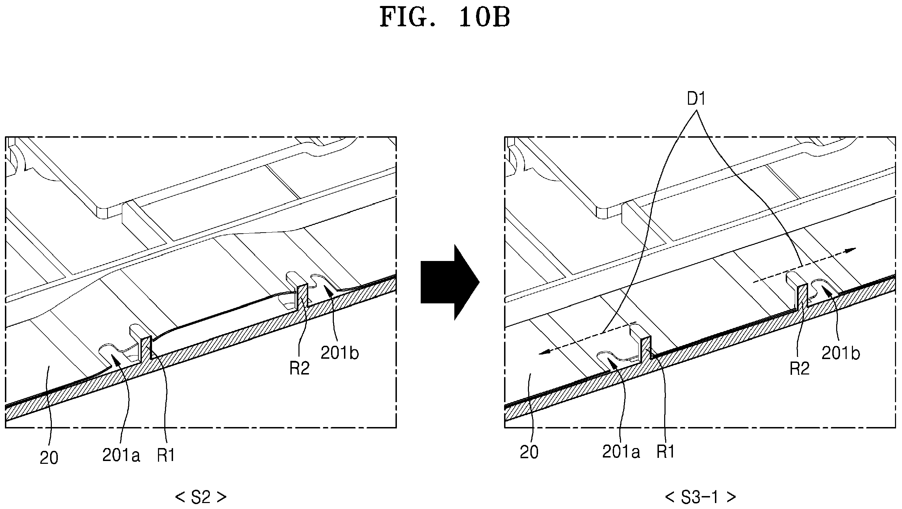

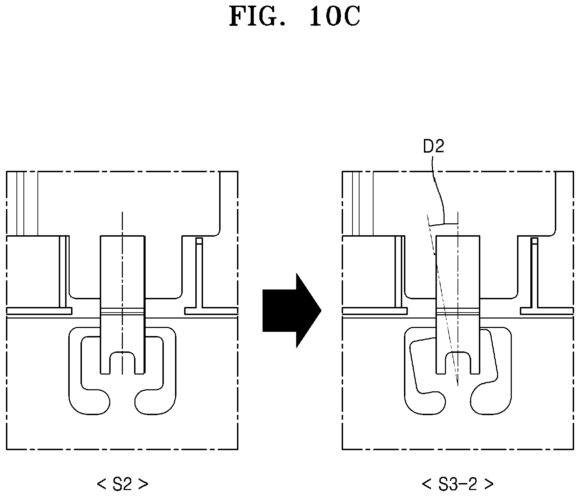

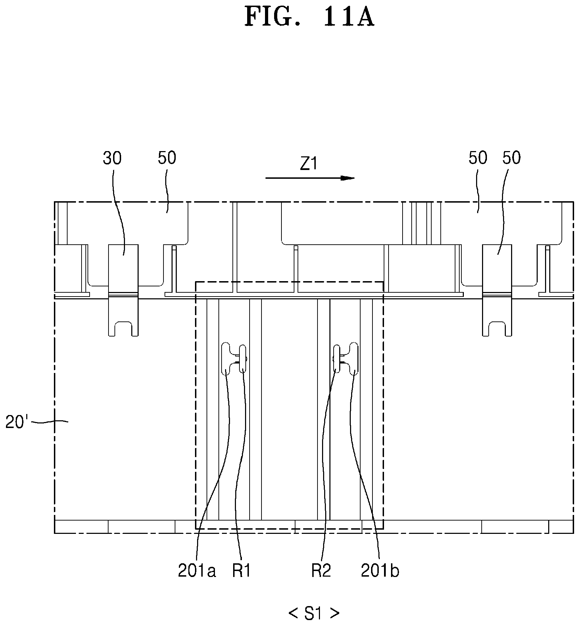

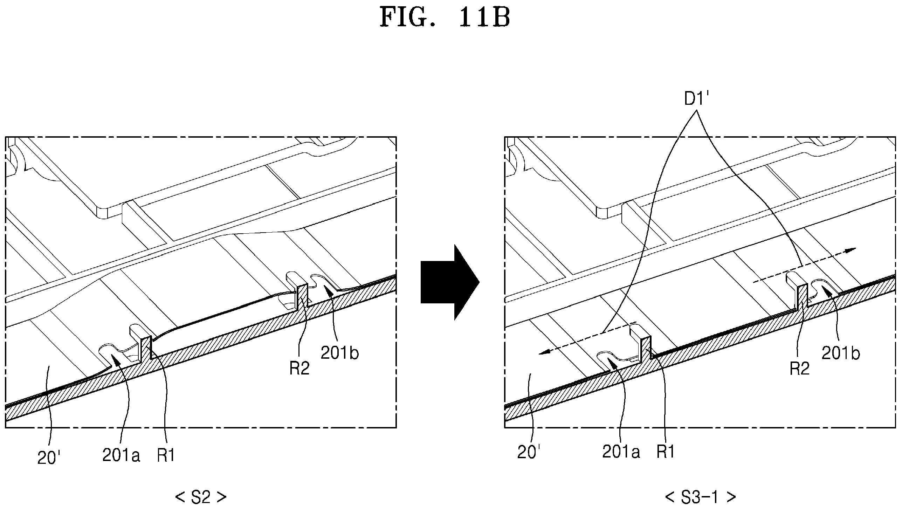

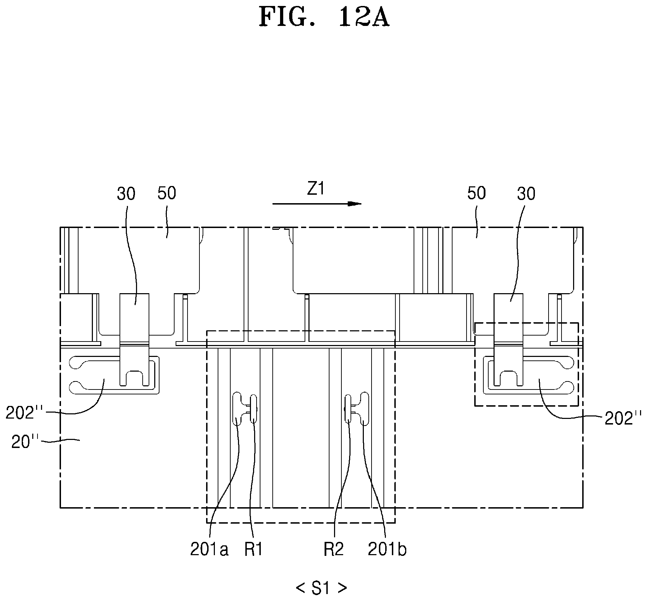

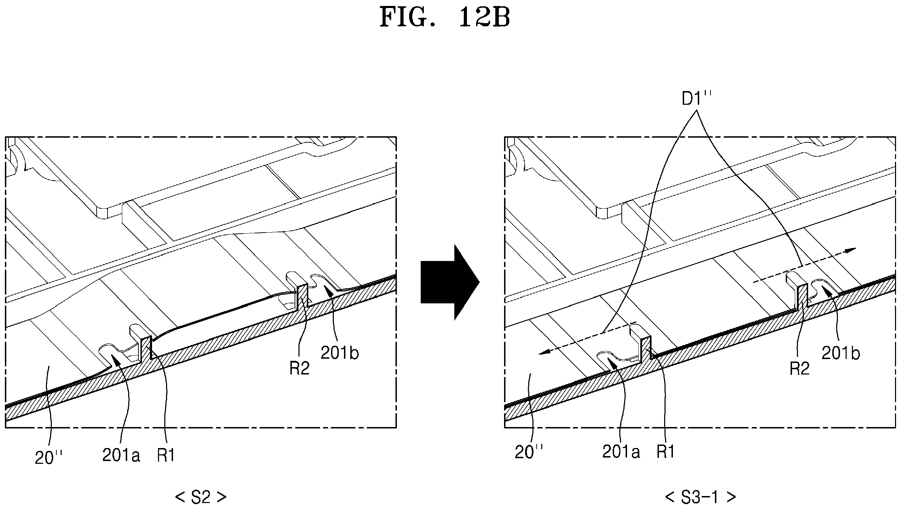

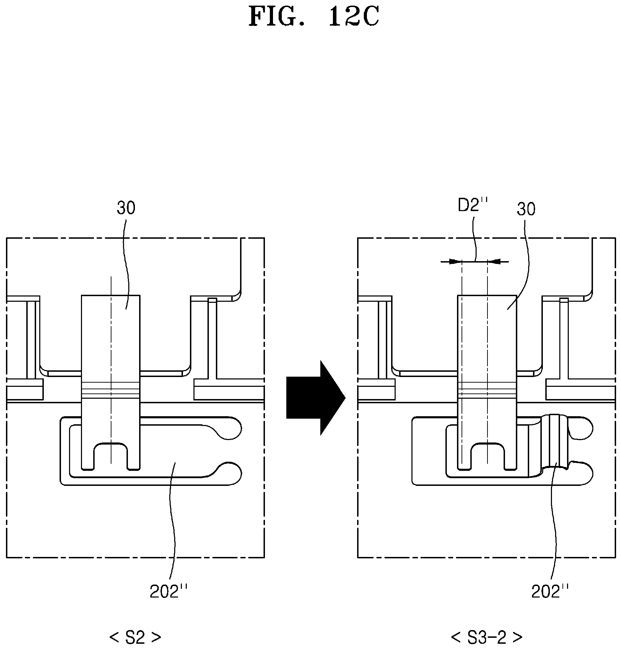

FIG. 10A is a diagram illustrating a structure of a sensing board and sensing terminals coupled thereto according to embodiments of the present disclosure. FIG. 10B includes diagrams showing that when displacement of the sensing terminals shown in FIG. 10A occurs, the sensing board is stretched to absorb the displacement by up to a first displacement value D1. FIG. 10C is includes diagrams showing that when displacement of the sensing terminals shown in FIG. 10A occurs, sensing board connecting portions are deformed in a direction perpendicular to a connection direction between the sensing board connecting portions and the sensing terminals to absorb the displacement by up to a second displacement value D2. FIG. 11A is a diagram illustrating a structure of a sensing board and sensing terminals coupled thereto according to embodiments of the present disclosure. FIG. 11B includes diagrams showing that when displacement of the sensing terminals shown in FIG. 11A occurs, the sensing board is stretched to absorb the displacement by up to a first displacement value D1'. FIG. 12A is a diagram illustrating a structure of a sensing board and sensing terminals coupled thereto according to embodiments of the present disclosure. FIG. 12B includes diagrams showing that when displacement of the sensing terminals shown in FIG. 12A occurs, the sensing board is stretched to absorb the displacement by up to a first displacement value D1". FIG. 12C includes diagrams showing that when a displacement of the sensing terminals shown in FIG. 12A occurs, sensing board connecting portions are deformed in a direction perpendicular to a connection direction between the sensing board connecting portions and the sensing terminals to absorb the displacement by up to a second displacement value D2".

Referring to FIGS. 10A and 10B, the sensing board 20, according to the illustrated embodiment, may further include sensing board connecting portions 202 connecting the sensing terminals 30 to the sensing board 20, and each of the sensing board connecting portions 202 may be connected to a portion of the sensing board 20 in a direction perpendicular to the first direction Z1. The sensing board connecting portion 202 may be arranged inside a recessed portion of the sensing board 20 and may be locally connected to only a portion of the sensing board 20 forming the recessed portion. The connection direction between the sensing board connecting portion 202 and the sensing board 20 may be a direction perpendicular to the first direction Z1.

When displacement of the sensing terminals 30 in the first direction Z1 occurs, as illustrated in FIG. 10B, the sensing board 20 may be stretched in the first direction Z1 to absorb the displacement by up to the first displacement value D1. In addition, as illustrated in FIG. 10C, the sensing board connecting portions 202 may be deformed in a direction perpendicular to the connection direction (e.g., in the first direction Z1) to absorb the displacement by up to the second displacement value D2.

As illustrated in FIG. 10C, the sensing board connecting portions 202 may absorb the displacement while tilting (or rotating) in the first direction Z1 with respect to the sensing board 20, and their maximum tilt angle may be the second displacement value D2.

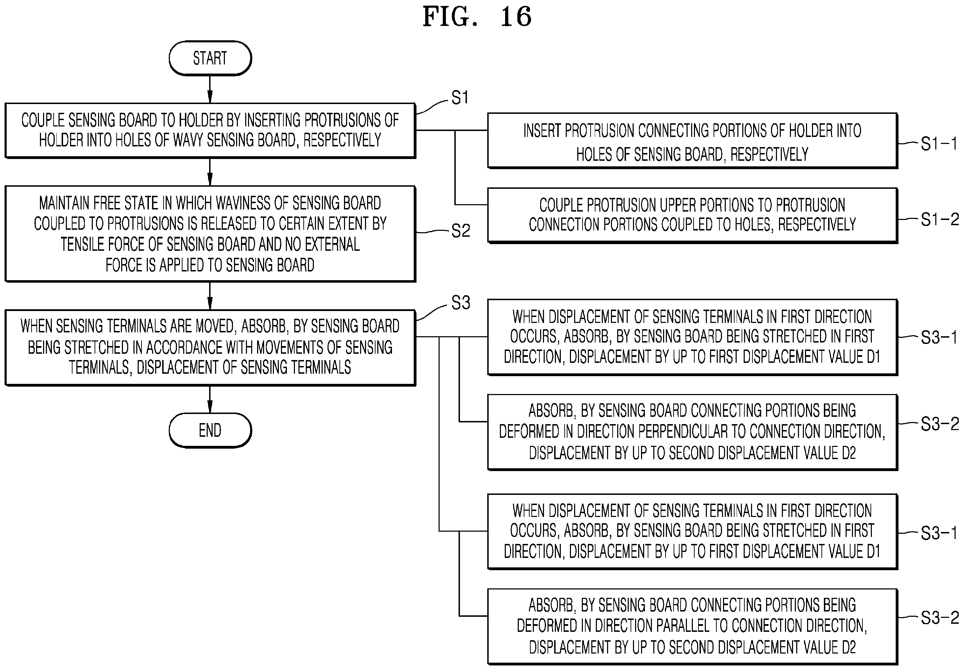

Referring to FIG. 16, in the method of manufacturing a battery pack according to an embodiment, the absorbing, by the sensing board 20 coupled to the sensing terminals 30, of the displacement of the sensing terminals 30 while being stretched in accordance with movements of the sensing terminals 30 (S3) may include, when displacement of the sensing terminals 30 in the first direction Z1 occurs, absorbing, by the sensing board 20 being stretched in the first direction Z1, the displacement by up to the first displacement value D1 (S3-1), and absorbing, by the sensing board connecting portions 202 being deformed in a direction perpendicular to the connection direction, the displacement by up to the second displacement value D2 (S3-2).

Referring to FIGS. 11A and 11B, different from the sensing board 20 shown in FIG. 10A, a sensing board 20' of a battery pack according to embodiments of the present disclosure may not include the sensing board connecting portions 202. In such an embodiment, when displacement of the sensing terminals 30 in the first direction Z1 occurs, the sensing board 20' may be stretched in the first direction Z1 to absorb the displacement by up to the first displacement value D1'.

Referring to FIGS. 12A and 12B, a sensing board 20" of a battery pack according to an embodiment may further include sensing board connecting portions 202" connecting the sensing terminals 30 to the sensing board 20", and each of the sensing board connecting portions 202" may be connected to a portion of the sensing board 20" in a direction perpendicular to the first direction Z1. The sensing board connecting portion 202" may be arranged inside a recessed portion of the sensing board 20" and may be locally connected to only a portion of the sensing board 20" forming the recessed portion. The connection direction between the sensing board connecting portion 202" and the sensing board 20" may be a direction parallel to the first direction Z1.

When displacement of the sensing terminals 30 in the first direction Z1 occurs, as illustrated in FIG. 12B, the sensing board 20" may be stretched in the first direction Z1 to absorb the displacement by up to the first displacement value D1". In addition, as illustrated in FIG. 12C, the sensing board connecting portions 202" may be deformed in a direction parallel to the connection direction (e.g., in the first direction Z1) to absorb the displacement by up to the second displacement value D2".

Referring to FIG. 16, in the method of manufacturing a battery pack according to the present embodiment, the absorbing, by the sensing board 20" coupled to the sensing terminals 30, of the displacement of the sensing terminals 30 while being stretched in accordance with movements of the sensing terminals 30 (S3) may include, when a displacement of the sensing terminals 30 in the first direction Z1 occurs, absorbing, by the sensing board 20", the displacement by up to the first displacement value D1 by being stretched in the first direction Z1 (S3-1), and absorbing, by the sensing board connecting portions 202" being deformed in a direction parallel to the connection direction, the displacement by up to the second displacement value D2" (S3-2).

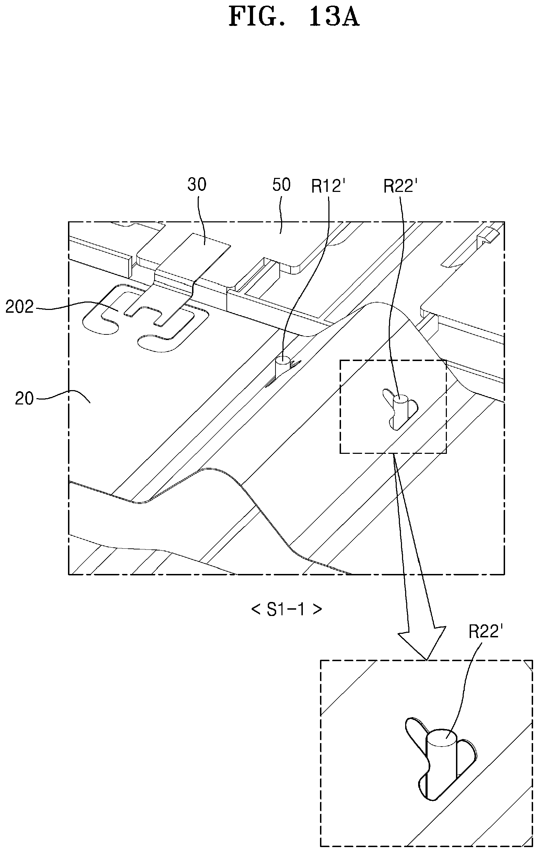

Hereinafter, a structure of protrusions of a battery pack and a method of manufacturing the battery pack according to some embodiments will be described with reference to FIGS. 13A, 13B, 13C, 14A, 14B, 14C, 15A, 15B, 15C, and 16.

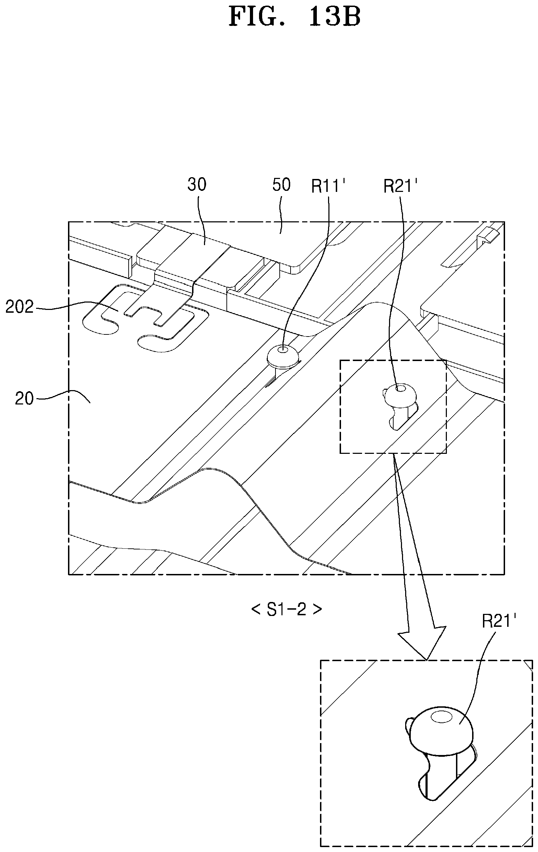

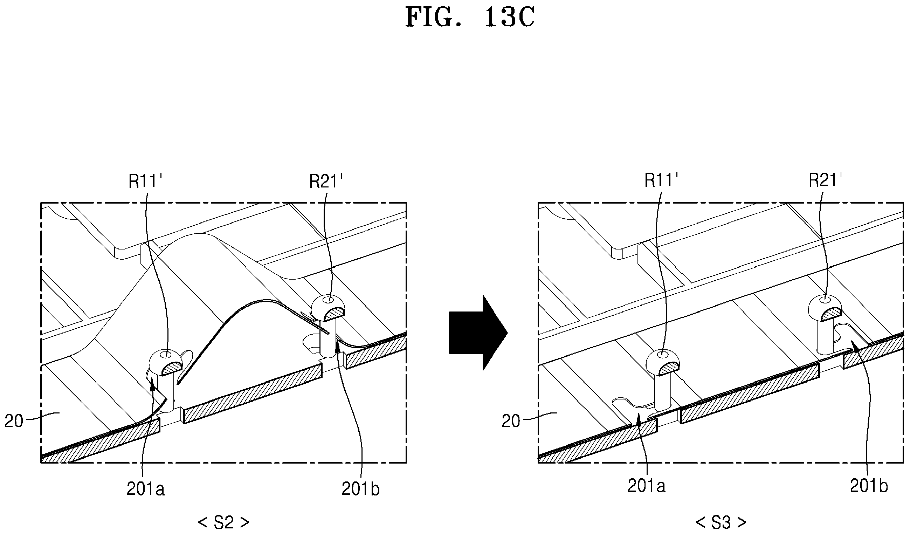

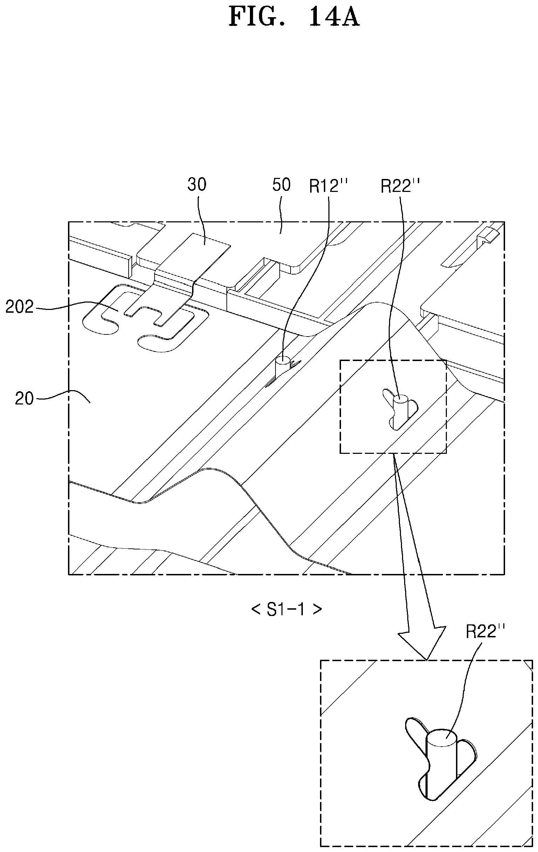

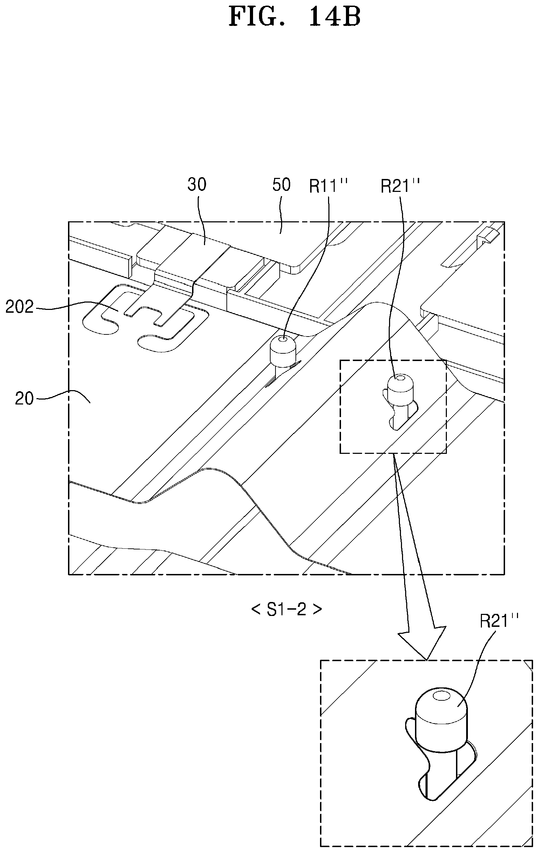

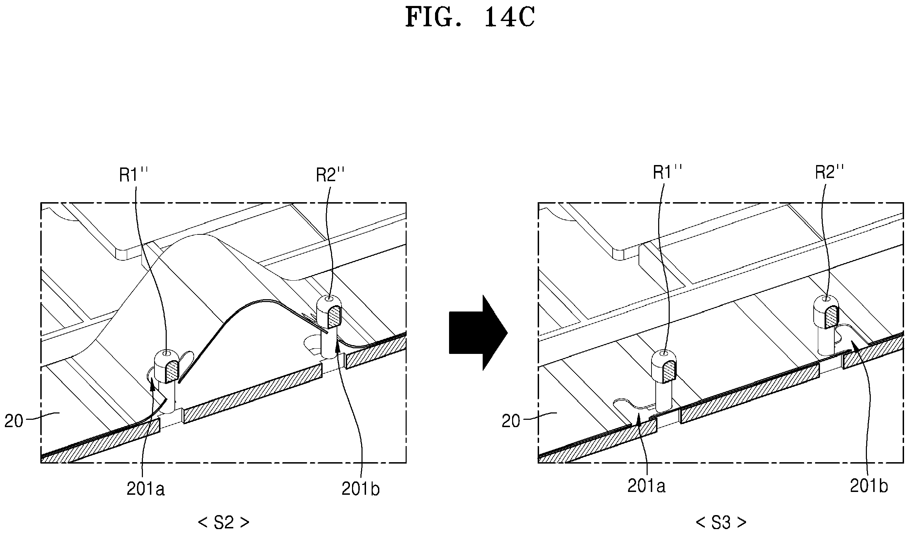

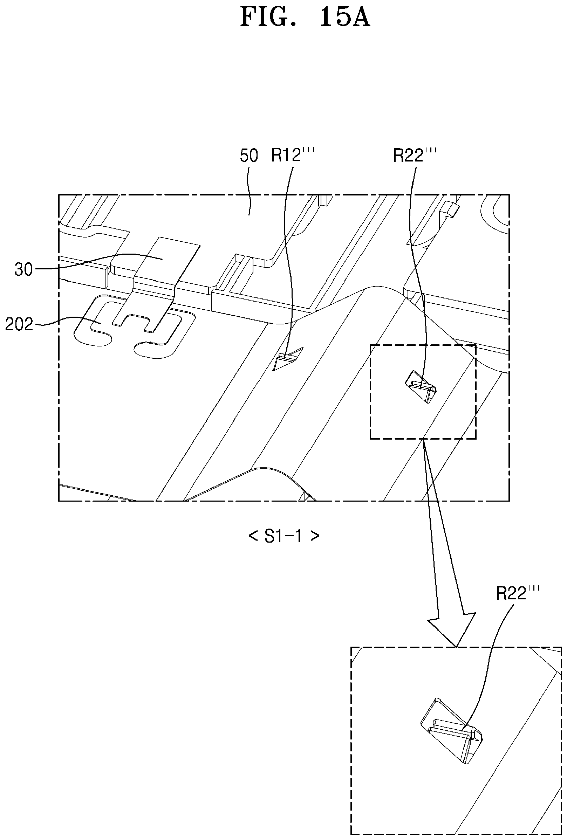

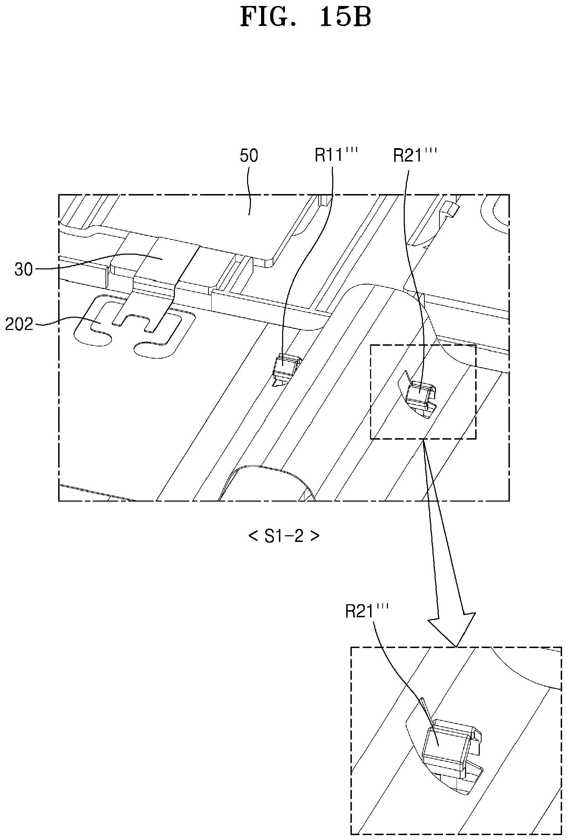

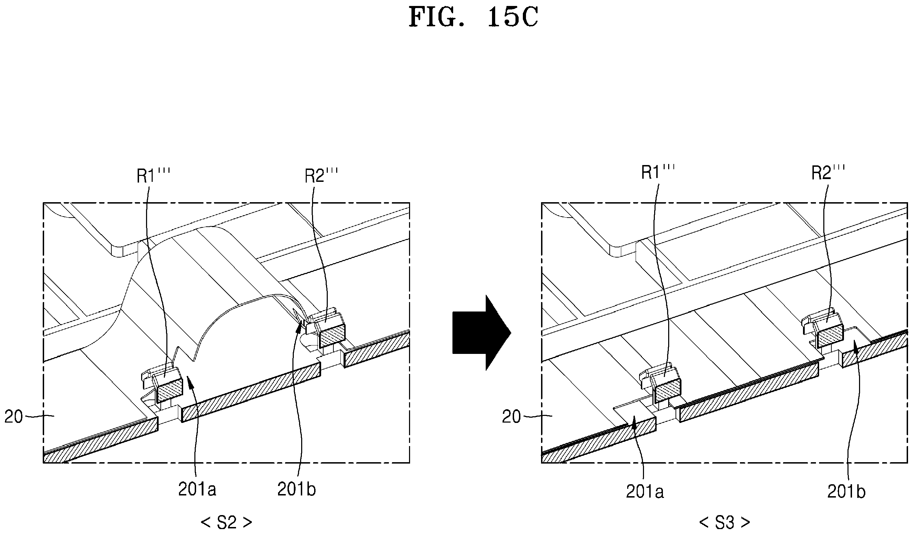

FIG. 13A is a diagram illustrating protrusion connecting portions of a holder inserted into holes in a sensing board, respectively, according to embodiments of the present disclosure. FIG. 13B is a diagram illustrating protrusion upper portions coupled to the protrusion connecting portions shown in FIG. 13A by using a heat stacking method. FIG. 13C includes diagrams showing the sensing board shown in FIG. 13B stretched to be flat. FIG. 14A is a diagram illustrating protrusion connecting portions of a holder inserted into holes in a sensing board, respectively, according to embodiments of the present disclosure. FIG. 14B is a diagram illustrating protrusion upper portions formed as caps fitted into the protrusion connecting portions shown in FIG. 14A, respectively. FIG. 14C includes diagrams showing the sensing board shown in FIG. 14B stretched to be flat. FIG. 15A is a diagram illustrating unspread snap-fit portions of a holder inserted into holes in a sensing board, respectively, according to embodiments of the present disclosure. FIG. 15B is a diagram illustrating, after insertion of the snap-fit portions into the holes in the sensing board shown in FIG. 15A, the sensing board coupled to the snap-fit portions by releasing an external force applied to the snap-fit portions such that the snap-fit portions are spread. FIG. 15C includes diagrams showing the sensing board shown in FIG. 15B stretched to be flat.

Referring to FIGS. 13A, 13B, and 13C, in the battery pack according to the illustrated embodiment, protrusion upper portions R11' and R21' may be coupled to protrusion connecting portions R12' and R22' by using a heat stacking method. In the method of manufacturing a battery pack according to the present embodiment, the coupling of the sensing board 20 to the holder H by inserting the protrusions of the holder into the holes in the wavy sensing board 20, respectively (S1), may include inserting the protrusion connecting portions R12' and R22' of the holder H into the holes 201a and 201b in the sensing board 20, respectively (S1-1), and coupling the protrusion connecting portions R12' and R22' to the protrusion upper portions R11' and R21' extending through the holes 201a and 201b, respectively (S1-2).

Accordingly, the sensing board 20 may be more easily coupled to the protrusion connecting portions R12' and R22' without the protrusion upper portion being present during the insertion. After the sensing board 20 is coupled to the protrusion connecting portions R12' and R22', the sensing board 20 may be completely coupled to the protrusions by coupling the protrusion upper portions R11' and R21' to the protrusion connecting portions R12' and R22' protruding from the sensing board 20. The protrusion upper portions R11' and R21' may have a wider width than the protrusion connecting portions R12' and R22' and the hole portions 201a and 201b. Accordingly, the sensing board 20 cannot escape from (e.g., cannot become detached from) due to the protrusions R1' and R2'. By coupling the protrusion upper portions R11' and R21' to the protrusion connecting portions R12' and R22' by using the heat stacking method, the protrusion upper portions R11' and R21' and the protrusion connecting portions R12' and R22' may be integrally formed by thermal compression. Such a coupling structure and method may be sufficiently implemented in an automated manufacturing process.

Referring to FIGS. 14A, 14B, and 14C, in the battery pack according to the present embodiment, protrusion upper portions R11" and R21" may be formed as caps and may be fitted onto protrusion connecting portions R12" and R22". In the method of manufacturing a battery pack according to the present embodiment, the coupling of the sensing board 20 to the holder H by inserting the protrusions of the holder H into the holes in the wavy sensing board 20, respectively (S1), may include inserting the protrusion connecting portions R12" and R22" of the holder H into the holes 201a and 201b in the sensing board 20, respectively (S1-1), and coupling the protrusion connecting portions R12" and R22" to the protrusion upper portions R11" and R21" extending through the holes 201a and 201b, respectively (S1-2).

Accordingly, the sensing board 20 may be more easily coupled to the protrusion connecting portions R12" and R22" without the protrusion upper portion being present during the insertion. After the sensing board 20 is coupled to the protrusion connecting portions R12" and R22", the sensing board 20 may be completely coupled to the protrusions by fitting the protrusion upper portions R1 1' and R21' onto the protrusion connecting portions R12" and R22" protruding from the sensing board 20. The protrusion upper portions R11" and R21" may have a wider width than the protrusion connecting portions R12" and R22" and the hole portions 201a and 201b. Accordingly, the sensing board 20 cannot escape from (e.g., cannot become detached) from protrusions R1" and R2". By coupling the protrusion upper portions R11" and R21" to the protrusion connecting portions R12" and R22" in a fitting manner, the protrusion upper portions R11" and R21" and the protrusion connecting portions R12" and R22" may be fixed together. Such a coupling structure and method may be sufficiently implemented in an automated manufacturing process.

Referring to FIGS. 15A, 15B, and 15C, in the battery pack according to the present embodiment, the protrusion upper portions R11‴ and R21‴ may include snap-fit portions R1‴ and R2‴, and the snap-fit portions R1‴ and R2‴ may be snap-fit to the sensing board 20. Here, in the method of manufacturing a battery pack according to the present embodiment, the coupling of the sensing board 20 to the holder H by inserting the protrusions of the holder H into the holes in the wavy sensing board 20, respectively (S1), may include inserting protrusion connecting portions R12‴ and R22‴ of the holder into the holes 201a and 201b in the sensing board 20, respectively (S1-1), and coupling the protrusion connecting portions R12‴ and R22‴ to the protrusion upper portions R11‴ and R21‴ coupled to the holes 201a and 201b, respectively (S1-2).

Accordingly, by inserting the folded snap-fit portions R1‴ and R2‴ into the holes 201a and 201b in the sensing board 20, respectively, and releasing the external force applied to the snap-fit portions R1‴ and R2'", the upper ends of the snap-fit portions are spread apart, and thus, the sensing board 20 may be coupled to the inside of (e.g., may be coupled under) the snap-fit portions R1‴ and R2'". Such a coupling structure and method may be sufficiently implemented in an automated manufacturing process.

The present disclosure has been described above with reference to embodiments as illustrated in the drawings, but these embodiments are only examples. Those of skill in the art will understand that various modifications and other equivalent embodiments may be derived from the described embodiments. Therefore, the scope of the present disclosure should be determined by the appended claims and their equivalents.

The technological details described herein in connection with the embodiments are illustrative examples and are not intended to limit the technological scope of the embodiments. To briefly and clearly describe the present disclosure, descriptions of general techniques and configurations in the art may be omitted.

Furthermore, line connections or connection members between elements depicted in the drawings represent functional connections and/or physical or circuit connections by way of example, and in actual applications, they may be replaced or embodied with various suitable additional functional connections, physical connections, or circuit connections. In addition, no item or component is essential to the practice of the present disclosure unless the item or component is specifically described as being "essential" or "critical".

In addition, the operations of all methods described herein may be performed in any suitable order unless otherwise indicated herein or otherwise clearly contradicted by context.

The embodiments are not limited to the described order of the operations. The use of any and all examples (e.g., "and the like") herein is intended merely to better illuminate embodiments and does not pose a limitation on the scope of the embodiments unless otherwise claimed.

In addition, those of skill in the art will understand that various modifications, combinations, and adaptations may be configured according to design conditions and factors without departing from the following claims and equivalents thereof.

In a battery pack and a method of manufacturing the battery pack according to embodiments of the present disclosure, when a battery cell in the battery pack swells, a wavy sensing board may absorb the corresponding displacement of the battery cell and sensing terminals connected to the battery cell.

The aspects and features of the present disclosure are not limited to the above-described aspects and features, and other aspects and features would be understood by those skill in the art from the description.

It should be understood that embodiments described herein should be considered in a descriptive sense and not for purposes of limitation. Descriptions of features or aspects within each embodiment should typically be considered as available for other similar features or aspects in other embodiments. While embodiments have been described with reference to the figures, it will be understood by those of ordinary skill in the art that various changes in form and details may be made therein.

## Claims

1. A battery pack comprising:
a plurality of battery cells;
busbars respectively connected to the plurality of battery cells;
a holder accommodating the busbars;
a sensing board seated on the holder, connected to the busbars, and extending in a wavy manner in a first direction, the sensing board having holes in both sides thereof; and
sensing terminals connecting the busbars to the sensing board and being configured to detect state information about the plurality of battery cells,
wherein the holder comprises protrusions respectively inserted into the holes, and
wherein the holes in the sensing board are configured to move with respect to the protrusions, in response to the sensing terminals moving, to stretch the sensing board.

2. The battery pack as claimed in claim 1, wherein each of the protrusions comprises:
a protrusion upper portion; and
a protrusion connecting portion connecting the protrusion upper portion to the holder, and
wherein each of the holes has:
a first hole portion having a first hole portion width corresponding to a width of the protrusion upper portion; and
a second hole portion having a second hole portion width corresponding to a width of the protrusion connecting portion.

3. The battery pack as claimed in claim 2, wherein the protrusion upper portions extend through the first hole portions, respectively, and
wherein, the protrusion connecting portions respectively pass through the first hole portions and/or the second hole portions.

4. The battery pack as claimed in any preceding claim, further comprising sensing board connecting portions respectively connecting the sensing terminals to the sensing board, and
wherein each of the sensing board connecting portions is connected to a portion of the sensing board in a direction perpendicular to the first direction.

5. The battery pack as claimed in claim 4, wherein the sensing board is configured to be, in response to displacement of the sensing terminals in the first direction, stretched in the first direction to absorb the displacement by up to a first displacement value, and
wherein the sensing board connecting portions are configured to be deformed in a direction perpendicular to a connection direction between the sensing board connecting portions and the sensing terminals to absorb the displacement by up to a second displacement value.

6. The battery pack as claimed in any preceding claim, further comprising sensing board connecting portions respectively connecting the sensing terminals to the sensing board, and
wherein each of the sensing board connecting portions is connected to a portion of the sensing board in a direction parallel to the first direction.

7. The battery pack as claimed in claim 6, wherein the sensing board is configured to be stretched in the first direction, in response to displacement of the sensing terminals in the first direction, to absorb the displacement by up to a first displacement value, and
wherein the sensing board connecting portions are configured to be deformed in a direction parallel to a connection direction between the sensing board connecting portions and the sensing terminals to absorb the displacement by up to a second displacement value.

8. The battery pack as claimed in any preceding claim, wherein the sensing board has a first area forming an edge portion of the sensing board and a second area forming an inner edge portion of the sensing board,
wherein the sensing board comprises:
a sensing terminal connecting portion at an end of the sensing terminal and electrically connected to the sensing board passing through the first area to be coupled to the second area of the sensing board;
a first circuit path formed in the first direction of the sensing board;
a second circuit path passing through the first area and electrically connected to the sensing terminal and another sensing terminal; and
a third circuit path electrically connected to the sensing terminal connecting portion of the sensing board in the second area, and
wherein the first circuit path, the second circuit path, and the third circuit path do not overlap each other.

9. The battery pack as claimed in any of claims 1 to 8, wherein the protrusion upper portions of the protrusions are respectively coupled to the protrusion connecting portions by a heat stacking method.

10. The battery pack as claimed in any of claims 1 to 8, wherein the protrusion upper portions of the protrusions are caps respectively fitted onto the protrusion connecting portions.

11. The battery pack as claimed in any of claims 1 to 8, wherein the protrusion upper portions of the protrusions respectively comprise snap-fit portions, and
wherein the snap-fit portions are snap-fit to the sensing board.

12. A method of manufacturing a battery pack, the method comprising:
coupling a wavy sensing board to a holder by inserting protrusions of the holder into holes in the sensing board, respectively;
maintaining a free state in which waviness of the sensing board coupled to the protrusions is released to a certain extent by a tensile force of the sensing board when no external force is applied to the sensing board; and
in response to sensing terminals being moved, absorbing, by the sensing board coupled to the sensing terminals, displacement of the sensing terminals while being stretched in accordance with movements of the sensing terminals.

13. The method as claimed in claim 12, wherein the battery pack comprises sensing board connecting portions that connect the sensing terminals to the sensing board, respectively, and are each connected to a portion of the sensing board in a direction perpendicular to a first direction, and
wherein the absorbing, by the sensing board coupled to the sensing terminals, of the displacement of the sensing terminals in response to the sensing terminals being moved while being stretched in accordance with the movements of the sensing terminals comprises:
in response to displacement of the sensing terminals in the first direction, absorbing, by the sensing board being stretched in the first direction, the displacement by up to a first displacement value; and
absorbing, by the sensing board connecting portions being deformed in a direction perpendicular to a connection direction between the sensing board connecting portions and the sensing terminals, the displacement by up to a second displacement value.

14. The method as claimed in claim 12 or claim 13, wherein the battery pack further comprises sensing board connecting portions that connect the sensing terminals to the sensing board, respectively, and are each connected to a portion of the sensing board in a direction parallel to a first direction, and
wherein the absorbing, by the sensing board coupled to the sensing terminals, of the displacement of the sensing terminals in response to the sensing terminals being moved while being stretched in accordance with the movements of the sensing terminals comprises, in response to displacement of the sensing terminals in the first direction:
absorbing, by the sensing board being stretched in the first direction, the displacement by up to a first displacement value; and
absorbing, by the sensing board connecting portions being deformed in a direction parallel to a connection direction between the sensing board connecting portions and the sensing terminals, the displacement by up to a second displacement value.

15. The method as claimed in any of claims 12 to 14, wherein the coupling of the wavy sensing board to the holder by inserting the protrusions of the holder into the holes of the sensing board, respectively, comprises:
inserting protrusion connecting portions of the holder into the holes in the sensing board, respectively; and
coupling protrusion upper portions to the protrusion connecting portions coupled to the holes, respectively.
